# EUROPEAN PATENT APPLICATION

(11) **EP 4 712 743 A1**
(43) Date of publication of application: **18.03.2026**
(21) Application number: 24807459.3
(22) Date of filing: 10.05.2024
(51) Int. Cl.: H10K 30/80, H10K 85/50, H10K 30/15, H10K 30/50, H10K 30/85, H10K 30/86, H10K 30/82, H10K 85/20, H10K 101/30

(54) **METHOD FOR MANUFACTURING PEROVSKITE SOLAR CELL AND PEROVSKITE SOLAR CELL WITH IMPROVED INTERFACIAL ENERGY MATCHING MANUFACTURED THEREBY**

(30) Priority: 12.05.2023 KR 20230061792
(71) Applicant: Hanwha Solutions Corporation, Jung-gu Seoul 04541 (KR)
(72) Inventor: CHOI, In Taek, Bucheon-si, Gyeonggi-do 14787 (KR)
(74) Representative: Mooser, Sebastian Thomas
(86) International application number: PCT/KR2024/006347
(87) International publication number: WO 2024/237584

(57) **Abstract**

The present invention relates to an interface treatment method of a perovskite layer for improving the performance of a perovskite solar cell and a perovskite solar cell interface-treated by the method and, specifically, to an interface treatment method of a perovskite layer for improving the performance of a perovskite solar cell and a perovskite solar cell interface-treated by the method, whereby the degradation of solar cell performance can be prevented by removing surface defects from the perovskite layer as well as improving energy matching with an electron transport layer.

## Description

### TECHNICAL FIELD

The present invention relates to an interface treatment method of a perovskite layer for improving the performance of a perovskite solar cell and a perovskite solar cell interface-treated by the method and, specifically, to an interface treatment method of a perovskite layer for improving the performance of a perovskite solar cell and a perovskite solar cell interface-treated by the method, whereby the degradation of solar cell performance can be prevented by removing surface defects from the perovskite layer as well as improving energy matching with an electron transport layer.

### BACKGROUND ART

Perovskite materials with a chemical formula of ABX₃ (most representative examples are organic and inorganic lead halide perovskite materials) have been actively applied to solar cells and have achieved a single-device efficiency of 25.2%. It is expected to soon reach the theoretical maximum solar cell efficiency of 30% considering light absorption efficiency and charge transfer characteristics. This efficiency is close to the highest efficiency of 26.6% for single-crystal silicon solar cells, and is higher than the efficiency of other polycrystalline silicon solar cells (22.3%) and CdTe solar cells (22.1%), showing the possibility of commercialization.

The operating principle of perovskite solar cells is that after light absorption, photo-excited charges are generated, and then, electrons and holes are separated by the internal potential of a device, and then, they diffuse to the electrodes and are finally collected. This operating method works efficiently when an ideal energy structure is formed, but in reality, there are defects in the perovskite inside the device that is being driven, which causes recombination of charges and causes a decrease in electromotive force.

The recombination principles related to this include Schockley-Read-Hall (SRH) recombination (recombination by traps existing in the bulk), Auger recombination (recombination due to the generation of a large amount of charges) and interfacial recombination (recombination due to misaligned energy levels, surface defects, etc.). Through this charge recombination, photo-excited charges lose energy in the form of heat rather than light. In addition, the recombination behavior induces the separation of Quasi-Fermi energy levels, which lowers the open circuit voltage (V_{OC}).

In order to prevent the degradation of perovskite, various control processes are required to remove defects. By mixing a defect control material into the perovskite precursor solution, the defects can be stabilized during the formation of a polycrystalline thin film, while the perovskite crystal growth behavior can be controlled, and a film with a largely controlled crystal grain size can be created. Alternatively, a defect control material can be covered on a pre-fabricated perovskite or prepared on a substrate in advance and used as a crystal composition layer, thereby enabling defect control and crystal growth control of the perovskite.

Conventional perovskite surface treatment technologies are technologies for improving perovskite thin films by applying organic substances including an A site (element corresponding to A in ABX₃) material that is capable of forming 2D perovskite with an ABX₃ chemical structure, a carboxyl group, a phosphate group or an ammonium ion that can combine with anionic or cationic defects on the perovskite surface to remove the defects.

These conventional perovskite surface treatment technologies have a problem in that the energy level matching with an electron transport layer laminated on the next layer is mismatched depending on the characteristics of the materials applied, which reduces the current (J_{SC}) and fill factor of the solar cell, thereby reducing the efficiency of the solar cell. In addition, the decrease in efficiency is most significant in p-i-n-structured solar cells.

Therefore, it is necessary to develop a method that can resolve surface defects while improving the energy level mismatch between the surfaces of a perovskite layer and an electron transport layer.

### DISCLOSURE

### TECHNICAL PROBLEM

The present invention has been devised to solve the above-described problems, and a problem to be solved by the present invention is to provide a method for surface treatment of a perovskite solar cell that is capable of minimizing a decrease in the efficiency of a perovskite solar cell by removing defects occurring on the surface of perovskite while simultaneously improving the surface roughness thereof and the matching of energy levels with the electron transport layer.

### TECHNICAL SOLUTION

In order to solve the above-described technical problems, the present invention provides a method for manufacturing a perovskite solar cell, the method including 1) forming a light-absorbing layer including a perovskite compound represented by Chemical Formula 1-1 below;
2) forming an interface layer by treating a perovskite surface treatment solution including two or more compounds that can be substituted at an A¹ or A² position of a compound represented by Chemical Formula 1-1 on the light-absorbing layer; and
3) forming an electron transport layer on the interface layer:

   [Chemical Formula 1-1] A¹ₐA²₁₋ₐPb(X¹_{b}X²_{1-b})₃
wherein in Chemical Formula 1-1 above, A¹ is a Cs cation, and A² is a monovalent organic cation,
wherein X¹ and X² are different halogen ions from each other,
wherein a is a real number from 0 to 0.25, and
wherein b is a real number from 0 to 1.

In a preferred embodiment of the present invention, in step 1), A² in Chemical Formula 1-1 may be an ammonium ion or amidinium ion that is substituted or unsubstituted with one or more aliphatic or aromatic hydrocarbons of C₁ to C₁₀.

In a preferred embodiment of the present invention in step 1), A² in Chemical Formula 1-1 may be one selected from formamidinium, phenethyl ammonium, ethylammonium, methylammonium and dimethylammonium ions.

In a preferred embodiment of the present invention, in step 2), a compound that can be substituted at an A¹ or A² position of the compound of Chemical Formula 1-1 may be any one of a compound represented by Chemical Formula 2 below, carboxylic acid having carbons of C₃ to C₁₀, phosphorous acid having carbons of C₃ to C₁₀ and a thiol compound having carbons of C₃ to C₁₀:

[Chemical Formula 2] A'X'

wherein in Chemical Formula 2 above, A' is an ammonium ion or amidinium ion that is substituted or unsubstituted with a monovalent metal cation or one or more aliphatic or aromatic hydrocarbons of C₁ to C₁₀, and
wherein X' is a halogen anion or a ⁻SCN anion.

In a preferred embodiment of the present invention, in step 2), at least one of compounds that can be substituted at an A¹ or A² position of two or more of the compound of Chemical Formula 1-1 included in the perovskite surface treatment solution may include an ion that is identical to at least one of an A¹ ion or A² ion of the perovskite compound included in the light-absorbing layer.

In a preferred embodiment of the present invention, in step 2), a compound that can be substituted at an A¹ or A² position of the compound of Chemical Formula 1-1 that includes an ion that is identical to at least one of an A¹ ion or A² ion of the compound of Chemical Formula 1-1 may be included in a content of 50 wt% to 75 wt% based on a total weight of compounds that can be substituted at an A¹ or A² position of two or more of the compound of Chemical Formula 1-1 included in the perovskite surface treatment solution.

In a preferred embodiment of the present invention, in step 2), the perovskite surface treatment solution may include two or more compounds that can be substituted at an A¹ or A² position of the compound of Chemical Formula 1-1 at a concentration of 2 mM to 15 mM, by using a C₂ to C₈ alcohol as a solvent.

In addition, the present invention provides a perovskite solar cell, including:
a transparent electrode layer;
a hole transport layer (HTL) formed on the transparent electrode layer;
a perovskite light-absorbing layer including a perovskite compound represented by Chemical Formula 1-1 below formed on the hole transport layer;
an interface layer formed on the perovskite light-absorbing layer and including two or more compounds selected from a compound represented by Chemical Formula 2 below, carboxylic acid having carbons of C₃ to C₁₀, phosphorous acid having carbons of C₃ to C₁₀ and a thiol compound having carbons of C₃ to C₁₀, as compounds that can be substituted at an A¹ or A² position of the perovskite compound;
an electron transport layer (ETL) formed on the interface layer; and
an upper electrode layer formed on the electron transport layer:

   [Chemical Formula 1-1] A¹ₐA²₁₋ₐPb(X¹_{b}X²_{1-b})₃

   [Chemical Formula 2] A'X'
wherein in Chemical Formula 1-1 above,
A¹ is a monovalent metal cation, and A² is a monovalent organic cation,
wherein X¹ and X² are different halogen ions from each other,
wherein a is a real number from 0 to 0.25,
wherein b is a real number from 0 to 1,
wherein in Chemical Formula 2 above,
A' is an ammonium ion or amidinium ion that is substituted or unsubstituted with a monovalent metal cation or one or more aliphatic or aromatic hydrocarbons of C₁ to C₁₀, and
wherein X' is a halogen anion or a ⁻SCN anion.

In a preferred embodiment of the present invention,
the energy level difference between a LUMO energy level of the interfacial layer and a LUMO energy level of the perovskite light-absorbing layer may be 0.3 eV or less. More preferably, it may be 0.1 eV or less.

In a preferred embodiment of the present invention, the electron transport layer may include fullerene.

### ADVANTAGEOUS EFFECTS

Unlike the conventional technique of using a single material to remove defects on the surface of a perovskite layer of a perovskite solar cell, when a perovskite solar cell is manufactured by using the method according to the present invention, the energy level matching between the electron transport layer and the perovskite layer can be easily matched, thereby improving the current (J_{SC}) and fill factor of a solar cell, and by removing anion or cation defects on the surface of a perovskite layer, the voltage (V_{OC}) can be improved, thereby ultimately maximizing the efficiency of a solar cell.

In addition, when a perovskite cell structure having the same structure as the perovskite solar cell of the present invention is applied as the upper cell of a silicon solar cell to produce a silicon/perovskite 2-terminal tandem series structure solar cell, the V_{OC} is improved compared to a silicon/perovskite 2-terminal tandem cell that applies a conventional perovskite solar cell, not the perovskite solar cell of the present invention, and ultimately, the efficiency of a tandem solar cell can be maximized.

### DESCRIPTION OF DRAWINGS

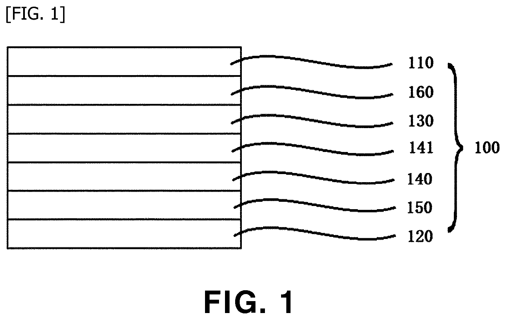

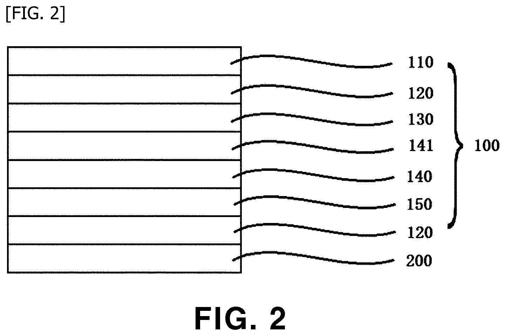

FIG. 1 and FIG. 2 are schematic drawings showing the layered structure of a perovskite solar cell on which surface treatment has been performed according to a preferred embodiment of the present invention.

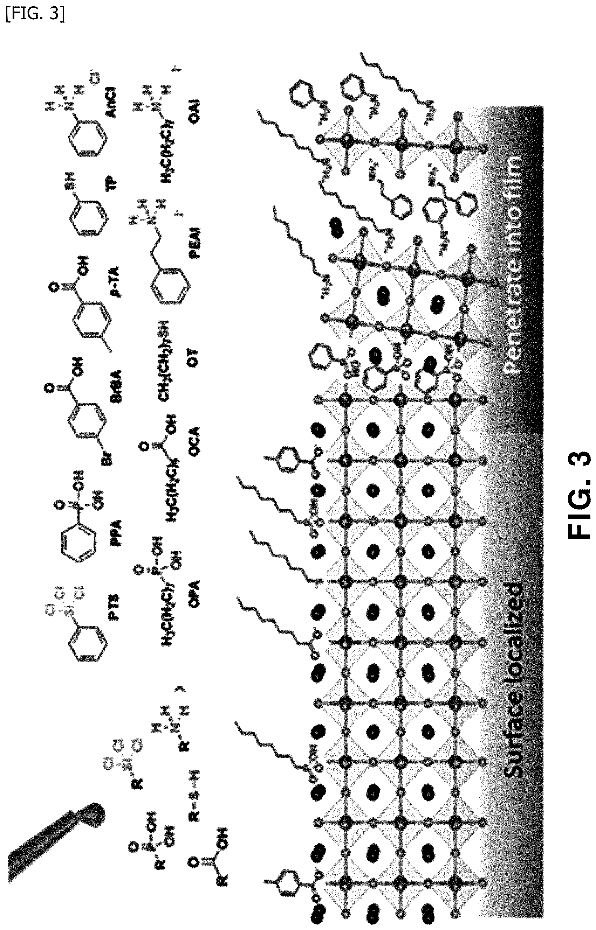

FIG. 3 is a diagram illustrating how surface defects in a perovskite layer that is surface-treated according to conventional techniques are affected by compounds included in a surface treatment solution. The precursors in the surface treatment solution react with perovskite surface defects to change the perovskite surface properties, and this change may have a positive or negative effect on the perovskite solar cell.

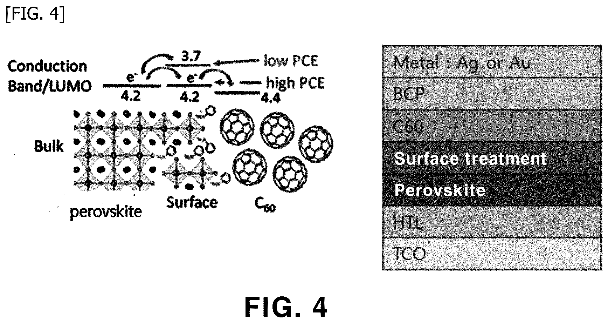

FIG. 4a shows the comparison of energy levels (middle energy level graph. LUMO is on the top, HOMO is on the bottom) that are changed when performing perovskite surface treatment according to the present invention (blue) and the prior art (red) with energy levels of the perovskite layer (left) and energy levels of the electron transport layer (right).
FIG. 4b is a diagram illustrating the comparison of the flow of charges between a perovskite layer and an electron transport layer when the surface of the perovskite layer is treated according to a conventional technique (left) and when the surface of the perovskite layer is treated according to a preferred embodiment of the present invention (right).

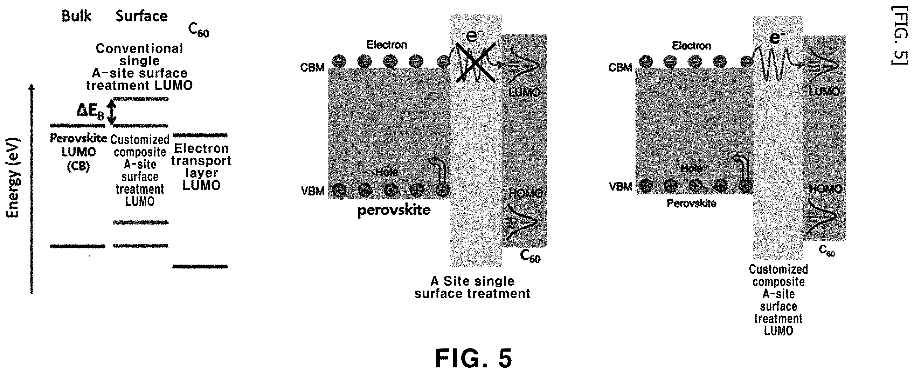

FIG. 5 is a drawing comparing the principle of charge transfer operation when the perovskite layer is surface-treated according to a conventional technique and when the perovskite layer is surface-treated according to a preferred embodiment of the present invention.

### MODES OF THE INVENTION

Before going into a detailed description of the constitutions and effects of the present invention, the meanings of terms used in the present specification will be explained.

In the present specification, the term "perovskite compound" means an inorganic compound having the same crystal structure as calcium titanate (CaTiO₃). In particular, it is composed of an ionic bond of A⁺B²⁺X⁻₃.

In the present specification, the term "a compound that can be substituted at an A¹ or A² site of the compound of Chemical Formula 1" means a compound having a monovalent cation that can be substituted at the site of the compound, because in Chemical Formula 1 below, A¹ and A² are monovalent cations. In addition, organic compounds that can release a hydrogen cation and act as a ligand that is capable of bonding with Pb⁺, such as carboxylic acid, phosphoric acid and thiol, are also included. This material is a material that can be substituted at an A site (i.e., A¹ or A² site) of the perovskite surface as a surface treatment material or bonded to a surface defect (Pb⁺).

[Chemical Formula 1] A¹ₐA²₁₋ₐBX₃

In Chemical Formula 1 above, A¹ and A² are monovalent cations, and a1 and a2 are real numbers from 0 to 1 that add to 1. When A is 0, Chemical Formula 1 becomes A²BX₃, and when a is 1, Chemical Formula 1 becomes A¹BX₃. B is a divalent metal cation, and preferably a divalent transition metal cation. More preferably, B is a lead (Pb) cation.

Hereinafter, the constitutions and effects of the present invention will be described in more detail.

As described above, the present invention provides a method for manufacturing a perovskite solar cell, the method including 1) forming a light-absorbing layer including a perovskite compound represented by Chemical Formula 1-1 below;
2) forming an interface layer by treating a perovskite surface treatment solution including two or more compounds that can be substituted at an A¹ or A² position of a compound represented by Chemical Formula 1-1 on the light-absorbing layer; and
3) forming an electron transport layer on the interface layer:

   [Chemical Formula 1-1] A¹ₐA²₁₋ₐPb(X¹_{b}X²_{1-b})₃
wherein in Chemical Formula 1-1 above, A¹ is a Cs cation, and A² is a monovalent organic cation,
wherein X¹ and X² are different halogen ions from each other,
wherein a is a real number from 0 to 0.25, and
wherein b is a real number from 0 to 1.

The present invention has been developed to prevent a decrease in the electron transport capability and, further, the performance of a perovskite solar cell due to a defect problem in the perovskite layer between the perovskite layer and the electron transport layer in a perovskite solar cell, by improving the problem of a decrease in the efficiency of a solar cell due to the generation of a high-energy barrier as a result of the surface treatment technology of a perovskite layer used in the prior art using a material that can be substituted for a single A ion site. The present invention uses a combination of materials that are capable of substituting two or more A ion sites to improve energy matching between a perovskite layer and an interface layer formed by surface treatment, thereby significantly increasing the efficiency of a solar cell.

In a preferred embodiment of the present invention, in step 1), A² in the Chemical Formula 1-1 may be an ammonium ion or amidinium ion that is substituted or unsubstituted with one or more aliphatic or aromatic hydrocarbons having a carbon number of C₁ to C₁₀.

In addition, in a preferred embodiment of the present invention, in step 1), A² in Chemical Formula 1-1 may be one selected from formamidinium, phenethyl ammonium, ethylammonium, methylammonium, and dimethylammonium ions.

More preferably, in step 1), the perovskite compound represented by Chemical Formula 1-1 may be a compound represented by Chemical Formula 1-2 below.

[Chemical Formula 1-2] CsₐFA₁₋ₐPb(I_{b}Br_{1-b})₃

In Chemical Formula 1-2 above, Cs represents a cesium cation, and FA represents a formamidinium cation. In addition, a is a real number from 0 to 0.25, and b is a real number from 0 to 1.

In a preferred embodiment of the present invention,
in step 2) above, the compound that can be substituted at an A¹ or A² position of the compound of Chemical Formula 1-1 may be any one of a compound represented by Chemical Formula 2 below, carboxylic acid having carbons of C₃ to C₁₀, phosphorous acid having carbons of C₃ to C₁₀ and a thiol compound having carbons of C₃ to C₁₀.

[Chemical formula 2] A'X'

In Chemical Formula 2 above, A' is an ammonium ion or amidinium ion that is substituted or unsubstituted with a monovalent metal cation or one or more aliphatic or aromatic hydrocarbons having C₁ to C₁₀, and X' is a halogen anion or a ⁻SCN anion.

In a preferred embodiment of the present invention,
in step 2), at least one of the compounds that can be substituted at an A¹ or A² position of two or more compounds of Chemical Formula 1-1 included in the perovskite surface treatment solution may include an ion that is identical to at least one of an A¹ ion or the A² ion of the perovskite compound included in the light-absorbing layer.

The present invention treats a surface treatment solution including a compound including a cation that is identical to the A¹ or A² cation of a perovskite compound included in a light-absorbing layer, and a mixed solution including a compound that is capable of substituting another A cation position together with the compound, thereby lowering the energy barrier compared to a case where treatment is performed including a single compound such that electron mobility can be further improved.

In a preferred embodiment of the present invention,
in step 2), the compound that can be substituted at an A¹ or A² position of the compound of Chemical Formula 1-1, which includes an ion that is identical to at least one of an A¹ ion or the A² ion of the compound of Chemical Formula 1-1, may be included in a content of 50 wt% to 75 wt% based on a total weight of two or more compounds that can be substituted at the A¹ or A² position of the compound of Chemical Formula 1-1 included in the perovskite surface treatment solution.

More preferably, among the compounds that can be substituted at an A¹ or A² cation position of the compound of Chemical Formula 1-1 above, the compound including the same cation as one of the A¹ cation or the A² cation of the perovskite compound included in the light-absorbing layer may be included in a content of 60 wt% to 70 wt% based on the total weight.

The surface treatment solution of step 2) may preferably be a mixed solution including two or three compounds that can be substituted at an A¹ ion or A² ion position of the compound of Chemical Formula 1-1. More preferably, it may be a solution including two compounds.

In a preferred embodiment of the present invention,
the perovskite surface treatment solution of step 2) may include two or more compounds that can be substituted at an A¹ or A² position of the compound of Chemical Formula 1 at a concentration of 2 mM to 15 mM, by using a C₂ to C₈ alcohol as a solvent.

The solvent may preferably be isopropyl alcohol (IPA).

In addition, the concentration of the surface treatment solution may more preferably be 7 mM to 10 mM.

In addition, the present invention also provides a perovskite solar cell, including:
a transparent electrode layer; a hole transport layer (HTL) formed on the transparent electrode layer; a perovskite light-absorbing layer including a perovskite compound represented by Chemical Formula 1-1 below formed on the hole transport layer; an interface layer formed on the perovskite light-absorbing layer and including two or more compounds selected from a compound represented by Chemical Formula 2 below, carboxylic acid having carbons of C₃ to C₁₀, phosphorous acid having carbons of C₃ to C₁₀ and a thiol compound having carbons of C₃ to C₁₀, as compounds that can be substituted at an A¹ or A² position of the perovskite compound; an electron transport layer (ETL) formed on the interface layer; and an upper electrode layer formed on the electron transport layer:

[Chemical Formula 1-1] A¹ₐA²₁₋ₐPb(X¹_{b}X²_{1-b})₃

[Chemical Formula 2] A'X'

wherein in Chemical Formula 1-1 above,
A¹ is a monovalent metal cation, and A² is a monovalent organic cation,
wherein X¹ and X² are different halogen ions from each other,
wherein a is a real number from 0 to 0.25,
wherein b is a real number from 0 to 1,
wherein in Chemical Formula 2 above,
A' is an ammonium ion or amidinium ion that is substituted or unsubstituted with a monovalent metal cation or one or more aliphatic or aromatic hydrocarbons of C₁ to C₁₀, and
wherein X' is a halogen anion or a ⁻SCN anion.

In a preferred embodiment of the present invention,
the energy level difference between a LUMO energy level of the interfacial layer and a LUMO energy level of the perovskite light-absorbing layer may be 0.3 eV or less, and more preferably 0.1 eV or less.

In a preferred embodiment of the present invention, the interface layer may be formed to have a thickness of 0.5 nm to 2 nm. If the thickness is less than 0.5 nm, the effect of the surface treatment may not be sufficient. However, on the contrary, if the thickness is more than 2 nm, the electron mobility may decrease due to the barrier characteristic, which may lower the efficiency of a solar cell.

In a preferred embodiment of the present invention, the electron transport layer may include fullerene. More preferably, it may include C₆₀ fullerene (buckminster fullerene).

Other solar cell constitutions may adopt constitutions that are generally used in the art for the operation of perovskite solar cells, which are selected from constitutions that can be easily selected by a person skilled in the art.

Hereinafter, the constitutions and effects of the present invention will be described in detail with specific examples. The following examples are provided to help understand the present invention and illustrate embodiments thereof, and are not intended to limit the scope of the present invention.

### <Example>

### Example 1

As a first electrode, a 2.5 cm × 2.5 cm ITO conductive transparent substrate having a substrate was immersed in a sodium hydroxide cleaning solution and ultrasonically cleaned for 1 hour, then washed by using distilled water and ethanol, and dried in a nitrogen gas atmosphere. The washed ITO conductive transparent substrate was partially etched with an IR laser, and then, a 30 nm thick NiOₓ (NiOₓ is a material in which Ni²⁺/Ni³⁺ coexist) layer was formed as a hole transport layer by using a deposition process.

Afterwards, 200 µL of a 1 mM to 5 mM concentration solution was dropped as an organic interface layer onto the NiOₓ layer, spin-coated at 3,000 rpm for 30 seconds, and then heat-treated at 100°C. Thereon, 100 µL of a solution including a perovskite precursor having a chemical formula of Cs_{0.2}FA_{0.8}Pb (I_{0.8}Br_{0.2})₃ (FA is formamidinium) was dropped again, and spin-coated at 5,000 rpm for 30 seconds. Nitrogen with a purity of 99% was blown during the spin-coating, and it was heat-treated at 100°C for 20 minutes to form a perovskite light-absorbing layer with a final thickness of 500 nm.

Afterwards, a 14 mM solution of PEAI/FAI in a weight ratio of 36:64 was applied as a surface treatment solution on the formed light-absorbing layer, and a 13 nm thick C₆₀ layer was formed thereon as an electron transport layer. 200 µL of a solution of 1 mg of bathocuproine (BCP) dissolved in 1 mL of isopropyl alcohol (IPA) was dropped on the formed electron transport layer, and spin-coated at 4,000 rpm for 30 seconds to form an exciton blocking layer, and then, a 100 nm thick Ag second electrode was formed by using a thermal evaporation device, so as to manufacture a perovskite photoelectric conversion device.

### Example 2

A perovskite solar cell was manufactured in the same manner as in Example 1, except that the surface treatment solution whose concentration was changed to 10 mM was treated.

### Example 3

A perovskite solar cell was manufactured in the same manner as in Example 1, except that the surface treatment solution whose concentration was changed to 8 mM was treated.

### Example 4

A perovskite solar cell was manufactured in the same manner as in Example 1, except that the surface treatment solution whose concentration was changed to 6 mM was treated.

### Example 5

A perovskite solar cell was manufactured in the same manner as in Example 1, except that the surface treatment solution whose concentration was changed to 2 mM was treated.

### Example 6

A perovskite solar cell was manufactured in the same manner as in Example 1, except that the surface treatment solution whose concentration was changed to 20 mM was treated.

### Comparative Example 1

A perovskite solar cell was manufactured in the same manner as in Example 1, except that a layer that was thermally deposited with LiF was formed as an interface layer.

### Comparative Example 2

A perovskite solar cell was manufactured in the same manner as in Example 1, except that the perovskite light-absorbing layer was treated by using an IPA solution in which 8 mM PEAI alone was dissolved as a perovskite surface treatment solution.

### Comparative Example 3

A perovskite solar cell was manufactured in the same manner as in Example 1, except that the perovskite light-absorbing layer was treated by using an IPA solution in which 8 mM of FAI alone was dissolved as a perovskite surface treatment solution.

**[Table 1]**

| | Perovskite Layer | Interface Layer | | Concentration |
|---|---|---|---|---|
| | | Composition | Ratio (Weight Ratio) | |
| Example 1 | Cs_{0.2}FA_{0.8}Pb(I_{0.8}Br_{0.2})₃ | PEAI /FAI | 0.36 / 0.64 | 14 mM |
| Example 2 | Cs_{0.2}FA_{0.8}Pb(I_{0.8}Br_{0.2})₃ | PEAI /FAI | 0.36 / 0.64 | 10 mM |
| Example 3 | Cs_{0.2}FA_{0.8}Pb(I_{0.8}Br_{0.2})₃ | PEAI /FAI | 0.36 / 0.64 | 8 mM |
| Example 4 | Cs_{0.2}FA_{0.8}Pb(I_{0.8}Br_{0.2})₃ | PEAI /FAI | 0.36 / 0.64 | 6 mM |
| Example 5 | Cs_{0.2}FA_{0.8}Pb(I_{0.8}Br_{0.2})₃ | PEAI /FAI | 0.36 / 0.64 | 2 mM |
| Example 6 | Cs_{0.2}FA_{0.8}Pb(I_{0.8}Br_{0.2})₃ | PEAI /FAI | 0.36 / 0.64 | 20 mM |
| Comparative Example 1 | Cs_{0.2}FA_{0.8}Pb(I_{0.8}Br_{0.2})₃ | LiF | - | Deposition process |
| Comparative Example 2 | Cs_{0.2}FA_{0.8}Pb(I_{0.8}Br_{0.2})₃ | PEAI | - | 8 mM |
| Comparative Example 3 | Cs_{0.2}FA_{0.8}Pb(I_{0.8}Br_{0.2})₃ | FAT | - | 8 mM |

### Experimental Example: Measurements of open circuit voltage, short circuit current, filling factor and efficiency

The photoelectric conversion efficiencies of the perovskite solar cells manufactured according to the above examples and comparative examples were measured by using a solar simulator (Solar simulator, Newport Co.). The measurement conditions were AM 15G (1 sun, 100 mW/cm2, 25°C). The open circuit voltage (VOC), short circuit current (JSC) and fill factor measured through the experiment and the photoelectric conversion efficiency calculated therefrom are shown in Table 2 below, respectively.

**[Table 2]**

| | V_{OC} | J_{SC} | Fill Factor | Best Eff. | Avq. Eff. |
|---|---|---|---|---|---|
| | (V) | (mA/cm²) | (%) | (%) | (%) |
| Example 1 | 1.191 | 21.501 | 78.42 | 20.09 | 19.89 |
| Example 2 | 1.185 | 21.279 | 78.81 | 19.87 | 19.67 |
| Example 3 | 1.178 | 21.323 | 80.61 | 20.25 | 20.18 |
| Example 4 | 1.161 | 21.244 | 80.56 | 19.87 | 19.87 |
| Example 5 | 1.183 | 21.079 | 78.12 | 19.48 | 19.29 |
| Example 6 | 1.177 | 21.105 | 80.09 | 19.89 | 19.71 |
| Comparative Example 1 | 1.154 | 20.642 | 75.94 | 18.41 | 18.10 |
| Comparative Example 2 | 1.150 | 19.32 | 64.12 | 14.55 | 14.10 |
| Comparative Example 3 | 1.152 | 19.48 | 67.93 | 15.24 | 15.10 |

Referring to Table 2 above, it can be seen that the photoelectric conversion efficiencies of Comparative Example 1 having a LiF deposition interface layer and Comparative Examples 2 and 3 using a single interface layer material were lower than those of the examples. In particular, the photoelectric conversion efficiencies of Comparative Examples 2 and 3 were significantly lower than those of the examples.

When comparing Examples 1 to 4, it can be seen that Example 3, in which the surface treatment solution was 8 mM of PEAI/FAI combined, had the most excellent photoelectric conversion efficiency.

However, when comparing Examples 5 and 6 together, it can be seen that Example 5, which had a low concentration of the surface treatment solution of 2 mM, and Example 6, which had an excessively high concentration, had lower photoelectric conversion efficiencies than Example 3.

Meanwhile, in the explanation of reference numerals, 100 represents a perovskite solar cell, 110 represents a metal electrode, 120 represents a transparent conductive oxide, 130 represents an electron transport layer, 140 represents a photoactive layer, 141 represents an interfacial layer, 150 represents a hole transport layer, 160 represents a BCP layer, and 200 represents a silicon solar cell.

## Claims

1. A method for manufacturing a perovskite solar cell, the method comprising:
1) forming a light-absorbing layer comprising a perovskite compound represented by Chemical Formula 1-1 below;
2) forming an interface layer by treating a perovskite surface treatment solution comprising two or more compounds that can be substituted at an A¹ or A² position of a compound represented by Chemical Formula 1-1 on the light-absorbing layer; and
3) forming an electron transport layer on the interface layer:
[Chemical Formula 1-1] A¹ₐA²₁₋ₐPb(X¹_{b}X²_{1-b})₃
wherein in Chemical Formula 1-1 above, A¹ is a Cs cation, and A² is a monovalent organic cation,
wherein X¹ and X² are different halogen ions from each other,
wherein a is a real number from 0 to 0.25, and
wherein b is a real number from 0 to 1.

2. The method of claim 1, wherein in step 1), A² in Chemical Formula 1-1 is an ammonium ion or amidinium ion that is substituted or unsubstituted with one or more aliphatic or aromatic hydrocarbons of C₁ to C₁₀.

3. The method of claim 2, wherein in step 1), A² in Chemical Formula 1-1 is one selected from formamidinium, phenethyl ammonium, ethylammonium, methylammonium and dimethylammonium ions.

4. The method of claim 1, wherein in step 2), a compound that can be substituted at an A¹ or A² position of the compound of Chemical Formula 1-1 is any one of a compound represented by Chemical Formula 2 below, carboxylic acid having carbons of C₃ to C₁₀, phosphorous acid having carbons of C₃ to C₁₀ and a thiol compound having carbons of C₃ to C₁₀
[Chemical Formula 2] A'X'
wherein in Chemical Formula 2 above, A' is an ammonium ion or amidinium ion that is substituted or unsubstituted with a monovalent metal cation or one or more aliphatic or aromatic hydrocarbons of C₁ to C₁₀, and
wherein X' is a halogen anion or a ⁻SCN anion.

5. The method of claim 4, wherein in step 2), at least one of compounds that can be substituted at an A¹ or A² position of two or more of the compound of Chemical Formula 1-1 comprised in the perovskite surface treatment solution comprises an ion that is identical to at least one of an A¹ ion or A² ion of the perovskite compound comprised in the light-absorbing layer.

6. The method of claim 5, wherein in step 2), a compound that can be substituted at an A¹ or A² position of the compound of Chemical Formula 1-1 that comprises an ion that is identical to at least one of an A¹ ion or A² ion of the compound of Chemical Formula 1-1 is comprised in a content of 50 wt% to 75 wt% based on a total weight of compounds that can be substituted at an A¹ or A² position of two or more of the compound of Chemical Formula 1-1 comprised in the perovskite surface treatment solution.

7. The method of claim 1, wherein in step 2), the perovskite surface treatment solution comprises two or more compounds that can be substituted at an A¹ or A² position of the compound of Chemical Formula 1-1 at a concentration of 2 mM to 15 mM, by using a C₂ to C₈ alcohol as a solvent.

8. A perovskite solar cell, comprising:
a transparent electrode layer;
a hole transport layer (HTL) formed on the transparent electrode layer;
a perovskite light-absorbing layer comprising a perovskite compound represented by Chemical Formula 1-1 below formed on the hole transport layer;
an interface layer formed on the perovskite light-absorbing layer and comprising two or more compounds selected from a compound represented by Chemical Formula 2 below, carboxylic acid having carbons of C₃ to C₁₀, phosphorous acid having carbons of C₃ to C₁₀ and a thiol compound having carbons of C₃ to C₁₀, as compounds that can be substituted at an A¹ or A² position of the perovskite compound;
an electron transport layer (ETL) formed on the interface layer; and
an upper electrode layer formed on the electron transport layer:
[Chemical Formula 1-1] A¹ₐA²₁₋ₐPb(X¹_{b}X²_{1-b})₃
[Chemical Formula 2] A'X'
wherein in Chemical Formula 1-1 above, A¹ is a monovalent metal cation, and A² is a monovalent organic cation,
wherein X¹ and X² are different halogen ions from each other,
wherein a is a real number from 0 to 0.25,
wherein b is a real number from 0 to 1,
wherein in Chemical Formula 2 above, A' is an ammonium ion or amidinium ion that is substituted or unsubstituted with a monovalent metal cation or one or more aliphatic or aromatic hydrocarbons of C₁ to C₁₀, and
wherein X' is a halogen anion or a ⁻SCN anion.

9. The perovskite solar cell of claim 8, wherein the energy level difference between a LUMO energy level of the interfacial layer and a LUMO energy level of the perovskite light-absorbing layer is 0.3 eV or less.

10. The perovskite solar cell of claim 9, wherein the energy level difference between a LUMO energy level of the interfacial layer and a LUMO energy level of the perovskite light-absorbing layer is 0.1 eV or less.

11. The perovskite solar cell of claim 8, wherein the electron transport layer comprises fullerene.
